(19) Europäisches Patentamt
European Patent Office
Office européen des brevets

(11) **EP 2 940 483 B1**

(12) **EUROPEAN PATENT SPECIFICATION**

(45) Date of publication and mention of the grant of the patent:
**05.04.2017 Bulletin 2017/14**

(51) Int Cl.:
***G01R 31/08*** (2006.01)

(21) Application number: **15163595.0**

(22) Date of filing: **14.04.2015**

(54) **EVALUATION METHOD FOR DETERMINING OF THE PROBABILITY OF AN ASYMMETRICAL FAULT LOCATION IN A DISTRIBUTION NETWORK AND A MONITORING SYSTEM FOR PERFORMING SUCH METHOD**

AUSWERTEVERFAHREN ZUR BESTIMMUNG DER WAHRSCHEINLICHKEIT EINER ASYMMETRISCHEN FEHLERORTUNG IN EINEM VERTEILUNGSNETZWERK UND ÜBERWACHUNGSSYSTEM ZUR DURCHFÜHRUNG EINES SOLCHEN VERFAHRENS

PROCEDE D'EVALUATION PERMETTANT DE DETERMINER LA PROBABILITE DE LOCALISATION DE DEFAUT ASYMETRIQUE DANS UN RESEAU DE DISTRIBUTION ET SYSTEME DE SURVEILLANCE POUR LA MISE EN OEUVRE DE CE PROCEDE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.04.2014 CZ 20140250**

(43) Date of publication of application:
**04.11.2015 Bulletin 2015/45**

(73) Proprietor: **Vysoké ucení technické v Brne 60190 Brno (CZ)**

(72) Inventors:
• **Topolanek, David 61200 Brno (CZ)**
• **Toman, Petr 60200 Brno (CZ)**
• **Orsagova, Jaroslava 62100 Brno (CZ)**

(74) Representative: **Malusek, Jiri Mendlovo namesti 1 a 603 00 Brno (CZ)**

(56) References cited:
• **NICK C WOOLLEY ET AL: "Statistical Estimation of the Source and Level of Voltage Unbalance in Distribution Networks", IEEE TRANSACTIONS ON POWER DELIVERY, vol. 27, no. 3, 1 July 2012 (2012-07-01), pages 1450-1460, XP011448211, IEEE SERVICE CENTER, NEW YORK, NY, US ISSN: 0885-8977, DOI: 10.1109/TPWRD.2012.2195230**
• **ORSAGOVA J ET AL: "Localization Method for the Resistive Earth Faults in Compensated Network Based on Simultaneous Earth Faults Evaluation", 12TH IET INTERNATIONAL CONFERENCE ON DEVELOPMENTS IN POWER SYSTEM PROTECTION (DPSP 2014), 2014, XP002744547, IET STEVENAGE, UK ISBN: 978-1-84919-834-9**

**Description**

Background of the Invention

The invention concerns the evaluation method for determining of the probability of an asymmetrical fault location in a distribution network.

State of the art

With regard to ensuring a safe operation and shortening periods without supply of electrical energy in the case of a single-phase fault, the most convenient and also the most widespread type of an electrical distribution network is a resonant earthed distribution network. During a single-phase earth fault in a resonant earthed distribution system, i.e. an earth fault, an arc-suppression coil compensates capacitive current which is flowing through a fault point of the affected system. Because of that, the level of a fault current is very low and independent on the place where an earth fault occurs. This considerably complicates a fast location of an earth fault and a subsequent fast elimination of cause of its occurrence and therefore fast restoration of power supply to customers.

In general, a fast and accurate location of a fault in electrical distribution networks, especially in isolated, resonant earthed or resistor earthed distribution networks, is very problematic. This is due to a high segmentation and complexity of electrical distribution networks caused by its purpose of distribution of electrical energy to all customers. Therefore, power distribution systems are formed by a huge number of feeders and branches, especially in densely populated areas.

According to the state of the art, it is possible to distinguish means, which can indicate a faulty feeder of an affected distribution network and means, which are able to directly locate a fault point inside whole distribution network. At the present time, the means for faulty feeder identification are relatively reliable, however the means or methods for determination of the place with the fault in wide distribution networks are not reliable and can increase the number of power supply interruptions. Therefore, the following description of the state of the art will be focused on the means or methods which can be used, with respect to their functional principle, for localization of the most frequently occurring an earth fault inside the monitored part of a distribution network.

One of the most widespread and most effective means for delimitation of a faulty section is successive process of disconnection of individual sections of an affected distribution network. The principle of the method consists in sequential disconnecting of individual sections or branches of affected feeder until an earth fault disappear. This method can be used to delimit faulty section of a line where after that operating personnel can be sent to this place to fix it. Disadvantage of the method is difficult and time consuming operation process and necessity of multiple interruption of power supply due to switching operation. Another disadvantage is that the delimited faulty section may have a long length, which requires further local search of a fault point. Furthermore, such multiple switching operation causes an overvoltage which can brink other serious problems.

Another known method, which doesn't require so many switching operations, is based on interconnecting of an faulty feeder and a healthy feeder outgoing from same substation to a ring connection, whereas calculation/estimation of a faulty place within a created ring is carried out on the basis of redistribution of negative sequence current to both feeders. Disadvantage of this method is that the interconnection of a faulty and healthy feeder of the same substation is not always feasible. Another problem, which obstructs a wider use of the method, is presence of non-homogenous parameters of power lines and high number of branches connected to a power line what complicates accurate location of an earth fault and in some cases, e.g. fault on one of branches of main power line, it is impossible to locate a fault. An accurate location of an earth fault in complicated distribution networks is made more difficult by measurement error of voltage and current conditions in supply substation and also by instability of considered parameters of individual elements of a network.

Another technical solution for an earth fault localization utilizes fault indicator units. This device can indicate a fault on the basis of monitored voltage and current conditions measured on power lines. Many different methods, which can detect a fault current presence at a measuring point or can indicate fault current direction are implemented to a fault indicator. These methods can analyze steady state or transient signals monitored by the indicators at the individual measuring points of a MV network. Localization of the faulty section is performed with respect to signalized fault direction indicated by fault indicators and actual distribution network topology. A faulty place is located by tracking of fault indicators indicating faulty state or direction of the fault from supply substation to the faulty section. If the indicators are equipped by remote signalization, a faulty section of the power system can be delimited in advance and then an operator can be sent directly to this location. Conversely, if the indicators are equipped only optical signalization, there is necessary to track personally all indicators placed on faulty line step by step up to the fault point, what is very time consuming process. An important requirement for the function of the method is a single-purpose arrangement of the indicators in a monitored distribution network. The result obtained by means of this method is not location of the specific place of a fault, but only specification of a part of the network which is affected by a fault. The size of this part depends on the number of installed indicators and its arrangement in a network, which is one of disadvantages of this fault location method. Another disadvantage is the necessity of the final location of the fault by an operator in the specified area of the network and complicated fault location in the case of malfunction of one of installed indicators.

The last group of the means intended for earth fault location in a distribution network is based on the calculation of the reactance/impedance of a power line connecting supply substation and a place affected by a fault. This reactance is after that used for calculation of electrical distance between supply substation and fault point. However, in most cases of complicated distribution network, the calculated electrical distance can correspond to more then one faulty place. Therefore, some additional earth fault location principle has to be used for localization of real fault point or there is necessary to physically verify all determined fault places. If only voltage and current conditions monitored at the supply substation are used for an earth fault location, total error of the calculated distance depends on measurement accuracy and used values of referential impedance of symmetrical components. Due to inaccuracy of used referential impedance especially zero sequence impedance and measurement error of voltage and current signals at faulty feeder of supply substation, the distance to the fault point can be calculated with significant error which complicates final determination of real fault point.

Another method referring to distribution system state estimation is known from Nick C Woolley et al: "Statistical Estimation of the Source and Level of Voltage Unbalance in Distribution Networks", IEEE Transactions on power delivery, IEEE Service Center, New York, vol.27, no.3, 1 July 2012, pages 1450-1460.

As follows from the above mentioned, it is important to find an optimal solution for fast and accurate earth fault location to ensure an improvement of power supply quality especially in resonant earthed distribution network, where location of an earth fault is more difficult. Because of the complications caused by operation of resonant earthed or isolated distribution networks, each of the above mentioned methods has disadvantages which prevent their widespread use.

The objective of the invention is to present an evaluation method for determination of probability of an asymmetrical fault location in a distribution network, which can eliminate the above mentioned disadvantages of the state of the art and to ensure a fast and accurate determination of a location affected by an asymmetrical fault. The presented solution quantifies the probability of presence of significant source of unbalance in the individual nodes of a monitored distribution network, wherein the source of such unbalance can be both any asymmetrical fault and any device connected to the electrical distribution network which can cause significant current/voltage unbalance in a monitored distribution network. Accordingly, the invention can be used for a localization of a significant source of unbalance which deteriorates the power quality in a distribution network. Nowadays, there is no method or a device which ensures localization of a place of a source of unbalance without time consuming partial measurements of voltage characteristics inside distribution network.

Feature of the Invention

The present invention is defined by the evaluation method having the features of independent claim 1. However, useful for the understanding of the present invention is a monitoring system for localisation of asymmetrical faults, comprising at least one monitoring unit and one evaluation unit, wherein a bi-directional communication is used between the evaluation unit and the monitoring unit and a control communication is used between the evaluation unit and a control unit, where the monitoring unit comprises at least one monitoring unit of a negative sequence voltage and at least one monitoring unit of a negative sequence current, wherein the monitoring unit of a negative sequence voltage is intended for monitoring of time synchronised waveforms of the change of negative sequence voltage measured on a secondary side of distribution transformers MV/LV in a monitored section of a distribution network, the monitoring unit of a negative sequence current is intended for monitoring and recording of time synchronised waveforms of the change of negative sequence current flowing through a supply transformer HV/MV, the evaluation unit is intended for determination of probability of asymmetrical fault presence or presence of a source of voltage/current unbalance in a monitored network on the basis of the changes of negative sequence voltage $\Delta U_{S,x}^{(2)}$ recorded by the monitoring units for given co-ordination time of a fault occurrence.

In an advantageous example the monitoring unit of a negative sequence current is further equipped with control communication means arranged between said monitoring unit and the control unit.

In another advantageous example the evaluation unit is split into a collecting device and an evaluation device, the collecting and the evaluation devices are interconnected.

In another advantageous example the monitoring unit of a negative sequence voltage is placed inside appropriate distribution transformer station MV/LV and connected to a secondary side of a distribution transformer MV/LV.

In another advantageous example the monitoring unit of a negative sequence current is placed on the secondary side of a power supply transformer HV/MV or in the incoming / outgoing feeder bays of a medium voltage substation S-MV.

In another advantageous example the monitoring unit of a negative sequence current comprises a voltage input for monitoring of a zero sequence voltage by means of direct measurements of neutral voltage performed by connection to a neutral point of a supply transformer HV/MV.

In another advantageous example the monitoring unit of a negative sequence current comprises voltage inputs for monitoring of a zero sequence voltage by means of calculation based on the phase voltages measurement in incoming or outgoing feeder bays of a medium voltage substation S-MV.

In another advantageous example the evaluation unit is further intended for collection and/or synchronisation and/or conversion of the time based records of the changes of negative sequence voltages and currents, said records are received from the appropriate monitoring units.

The above mentioned disadvantages are significantly eliminated by use of an evaluation method for determination of probability of an asymmetrical fault location in a distribution network,
where a negative sequence scheme of a monitored distribution network is created, the co-ordination time of fault occurrence is evaluated on the basis of the exceeded threshold value of the change of negative sequence current, the records of the changes of negative sequence voltage measured on the secondary sides of appropriate distribution transformers MV/LV and the records of the changes of negative sequence currents flowing through supply transformers HV/MV are collected for the given co-ordination time of fault occurrence, the collected records are used for determining the maximum change of negative sequence voltage and current, said maximum change corresponds to the moment when the sum of all the recorded changes of negative sequence voltage reaches its maximum value, the values of the maximum change of negative sequence voltage are converted to the primary side of the appropriate distribution transformer MV/LV, the values of the converted maximum change of negative sequence voltage and the maximum change of negative sequence current are used to calculate values of the error of changes of negative sequence voltage for the individual measuring nodes, the total errors for the individual nodes, the percentage value of the probability of fault presence or presence of a source of voltage unbalance for individual nodes of the monitored distribution network.

In an advantageous example a graphical visualisation depicting probability of an asymmetrical fault location and/or location of a source of voltage/current unbalance for individual nodes is carried out.

Description of the Drawings

The invention will be further explained with reference to the drawings, in which:

Fig. 1 presents a resonant earthed distribution network with a possible connection of an auxiliary resistor to the power winding of an arc-suppression coil comprising a monitoring system installed therein.
Fig. 2 presents a possible way of connecting monitoring units configured to monitor a negative sequence voltage to the low voltage side of a distribution transformer,
Fig. 3 presents possible ways of connecting a monitoring unit configured to monitor a negative sequence current to an electrical distribution network,
Fig. 4 presents a unit configured to monitor negative sequence current and equipped with an additional voltage input for monitoring a zero sequence voltage by means of a direct connection to a neutral point of a supply transformer,
Fig. 5 presents a unit configured to monitor negative sequence current and equipped with a voltage input for monitoring a zero sequence voltage by measuring phase voltages in incoming or outgoing feeders,
Fig. 6 presents an example of a simplified distribution network with marked measuring points of a change in the negative sequence voltage and current,
Fig. 7 presents a negative sequence scheme of the distribution network shown in Fig. 6 for the purpose of describing the method according to the invention,
Fig. 8 presents a distribution network for of the purpose of describing the method according to the invention with a marked place of a fault,
Fig. 9 presents one of the waveforms of negative sequence voltage measured at measuring points in the exemplary distribution network shown in Fig. 8,
Fig. 10 presents one of the waveforms of the changed negative sequence voltage measured at measuring points in the exemplary distribution network shown in Fig. 8,
Fig. 11 presents a waveform of the sum of all the recorded changes in the negative sequence voltage in the exemplary distribution network shown in Fig. 8,
Fig. 12 presents unified/time synchronised waveforms of the recorded change in the negative sequence voltage in the exemplary distribution network shown in Fig. 8,
Fig. 13a presents a resonant earthed distribution network with a possible connection of an auxiliary resistor to the power winding of an arc suppression coil, where the monitoring system is installed,
Fig. 13b presents a resonant earthed distribution network with possible connection of an auxiliary resistor in parallel to an arc suppression coil, where the monitoring system is installed,

Fig. 13c presents a resonant earthed distribution network without an auxiliary resistor, where the monitoring system is installed,

Fig. 14a presents an isolated distribution network with possible connection of an auxiliary resistor to a neutral point of a supply transformer, where the monitoring system is installed,

Fig. 14b presents an isolated distribution network, with the installed monitoring system,

Fig. 14c presents a distribution network earthed through a node resistor, with the installed monitoring system.

Preferred Embodiments of the Invention

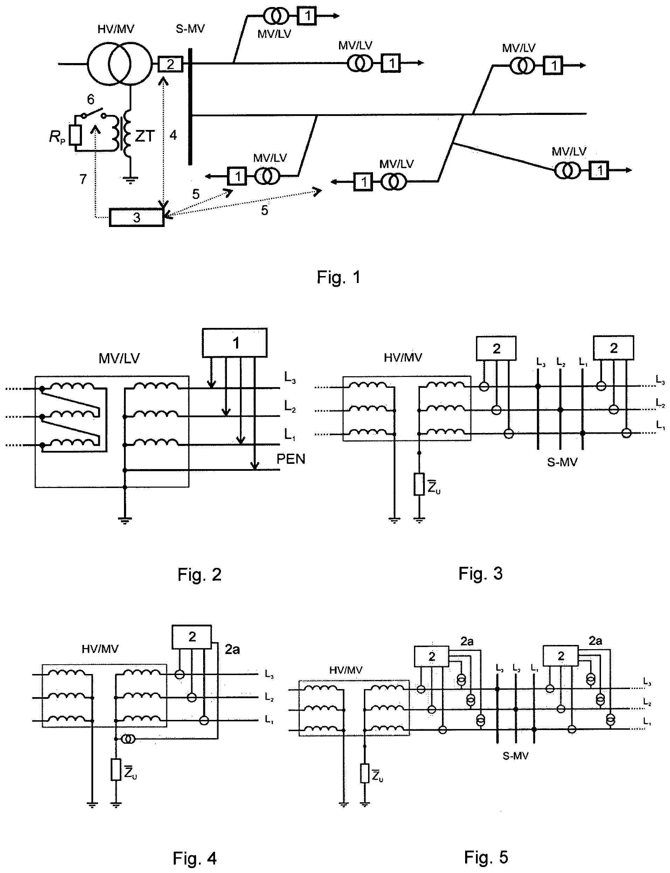

The monitoring system configured to perform the evaluation method for determining the probability of an asymmetrical fault location in the distribution network, which is presented in Fig. 1, comprises:

- a monitoring unit comprising at least one unit 1 for monitoring negative sequence voltage, in short "MZSN", and/or at least one unit 2 for monitoring negative sequence current, in short "MZSP",
- an evaluation unit 3,
- communications 4, 5 between the evaluation unit 3 and the monitoring unit 1, 2,
- a communication 7 between the evaluation unit 3 and a the control unit 6.

MZSN 1

- The MZSN 1 is placed inside the distribution transformer stations MV/LV, i.e. stations for transforming medium voltage to low voltage, on the secondary sides of the distribution transformers MV/LV in the monitored section of a distribution network, see the detail shown in Fig. 2.
- The MZSN 1 monitors the changes in the negative sequence voltage, in short $\Delta U_{Sx}^{(2)}$, caused by voltage unbalances or by a fault current flowing through the monitored section of a distribution network.
- Storing of a recorded negative sequence voltage waveform can be performed continuously or on an individual basis, when predetermined threshold value of the change in the negative sequence voltage is exceeded.
- The storage, for saving the measured values, can be an internal one, e.g. a part of the MZSN 1, or an external one, e.g. outside of the MZSN 1, for example a part of the evaluation unit 3.

MZSP 2

- The MZSP 2_is connected to the secondary side of a power supply transformer HV/MV in a monitored distribution system, i.e. a transformer for transforming high voltage to medium voltage, respectively connected to the incoming and/or outgoing feeders of a medium voltage substation S-MV, see the detail shown in Fig. 3.
- The MZSP 2 can be equipped with a voltage input 2a, which monitors a zero sequence voltage by means of a direct measurement at a neutral point of the power supply transformer HV/MV, see Fig. 4, or by means of a calculation based on the measured phase voltages on the incoming or outgoing feeders of a medium voltage substation S-MV, see Fig. 5.
- The MZSP 2 monitors the change in the negative sequence current $\Delta I_f^{(2)}$, obtained from a calculation based on measured load currents of monitored section of a distribution network.
- In the case that a fault is detected, i.e. when a predetermined threshold value of the change in the negative sequence current is exceeded or when the zero sequence voltage exceeds a predetermined threshold value, the MZSP 2 determines the co-ordination time of the fault occurrence and stores the information relating to that time along with a record of the change in the negative sequence current waveform ranging from predetermined "pre-trigger" to predetermined "post-trigger", as described below.
- The information relating to the negative sequence current can be stored continuously or at a specific moment, when a predetermined threshold value of the change in the negative sequence current is exceeded, or when the zero sequence voltage exceeds a predetermined threshold value in case that zero sequence voltage is monitored by MZSP 2.
- If a fault is detected, the MZSP 2 transmits a record of $\Delta I_f^{(2)}$ and an information relating to the co-ordination time of the fault occurrence to the evaluation unit 3.

- The storage, where measured values are saved can, be an internal storage, i.e. a part of the MZSP 2, or an external storage, i.e. outside of the MZSP 2, for example a part of the evaluation unit 3.

Evaluation unit 3

- Based on triggering event sent from the MZSP 2 and informing that a fault occurred, the evaluation unit 3 collects the records of changes in the negative sequence voltage waveforms $\Delta U_{Sx}^{(2)}$ recorded by individual MZSNs 1 for any given co-ordination time of fault occurrence with respect to predetermined "pre-trigger" and "post-trigger" of the records.
- When all available records of negative sequence voltage and current are collected by the evaluation unit 3, the latter carries out their synchronisation and conversion into a desired format.
- On the basis of the maximum recorded changes in the negative sequence voltage $\Delta U_{Sx\_M}^{(2)}$ and on the basis of the maximum recorded changes in the negative sequence current $\Delta I_{f\_M}^{(2)}$ obtained through the analysis of all collected records, the evaluation unit 3 identifies the most probable fault location in a monitored distribution network, wherein the node voltage method applied to a negative sequence diagram of the monitored electrical distribution network is used.

The evaluation unit 3 can be advantageously split into two devices:

- a collecting device which is, for example, configured for data collection, synchronisation and conversion, and
- an evaluation device which is configured for a further determination of a probable fault location or a probable place affected by a source of voltage unbalance.

Both the devices are mutually interconnected by data transfer communication means.

The units 1, 2 a 3 are mutually time synchronised in order to maximise the accuracy of the time synchronisation of records.

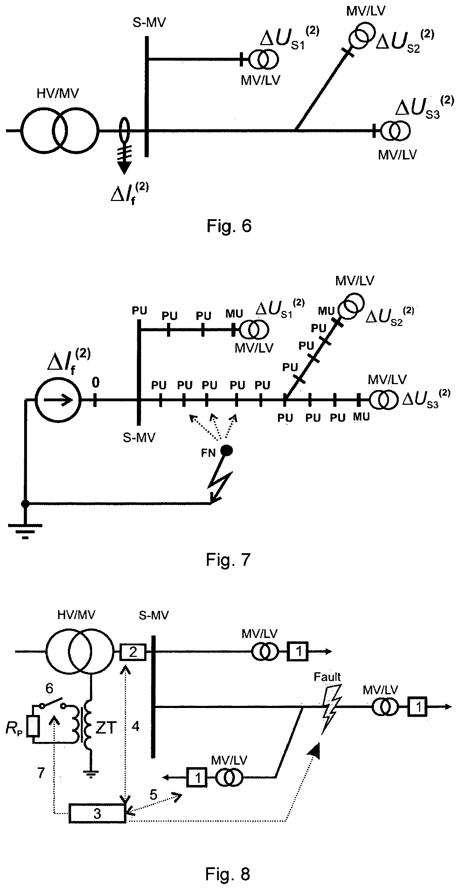

An exemplary negative sequence scheme of a simplified distribution network according to Fig 6. is shown in Fig 7. For the purpose of the description of the presented method, the negative sequence scheme is modified in a situation when each section of the electrical distribution network is divided to individual network elements by means of auxiliary nodes PU, wherein the distribution network also includes measuring nodes MU which correspond to the locations where the MZSNs 1 are installed. The accuracy of the location algorithm is higher when the distances between the individual elements of the monitored network are smaller.

Between the evaluation unit 3 and the MZSN 1 and MZSP 2 respectively, there is the two way communication 4, 5 which is used for transferring the measured or recorded data, transmitting instructions or for another purpose. The monitoring system can be preferably supplemented with the control communication 7 connecting the evaluation unit 3 and the control element 6 of the system, or it with the communication 8 connecting the MZSP 2 and the control element 6 of the system the latter communication being intended for switching the control element 6. All the communication channels used in the system can be designed in a cable version or in a wireless version.

The principle of the evaluation method for determining the probability of an asymmetrical fault location in a distribution network according to the invention, presented in Fig. 6, is described in Fig. 8 in more detail, where a place with a fault and a concept of connection of the monitoring system configured to perform the method is presented:

The monitoring units MZSN 1 monitor the changes in the negative sequence voltage $\Delta U_{Sx}^{(2)}$ occurred on low-voltage sides of all accessible distribution transformers MV/LV. When the triggering event occurs, i.e. when change in the negative sequence voltage $\Delta U_{Sx}^{(2)}$ exceeds the threshold value preset at the MZSN 1, the information about that time and the recorded waveform of negative sequence voltage with respect predefined pre-trigger and post-trigger are stored in a storage of the MZSN 1, wherein the value of the pre-trigger specifies a time period before the time of triggering event for which the record is stored, and the value of the post-trigger specifies a time period after the time of triggering event for which the record is stored.

In another embodiment, the change in the negative sequence voltage $\Delta U_{Sx}^{(2)}$ can be continuously saved to circular memory until the moment, when the record is required by evaluation unit 3 for a determined co-ordination time extended by the predefined pre-trigger and post-trigger.

The MZSP 2 monitors a synchronised change in the negative sequence current $\Delta I_{\mathrm{f}}^{(2)}$ flowing through the power supply transformer/transformers HV/MV feeding monitored medium-voltage distribution network. In the case that occurrence of a fault is detected, i.e. co-ordination time is determined, a record of negative sequence current waveform for the co-ordination time extended by predefined pre-trigger and post-trigger is stored in a storage of the MZSP 2 and then transmitted along with the co-ordination time to the evaluation unit 3.

The individual steps of the evaluation method for determining the probability of an asymmetrical fault location in a distribution network are described below:

First step

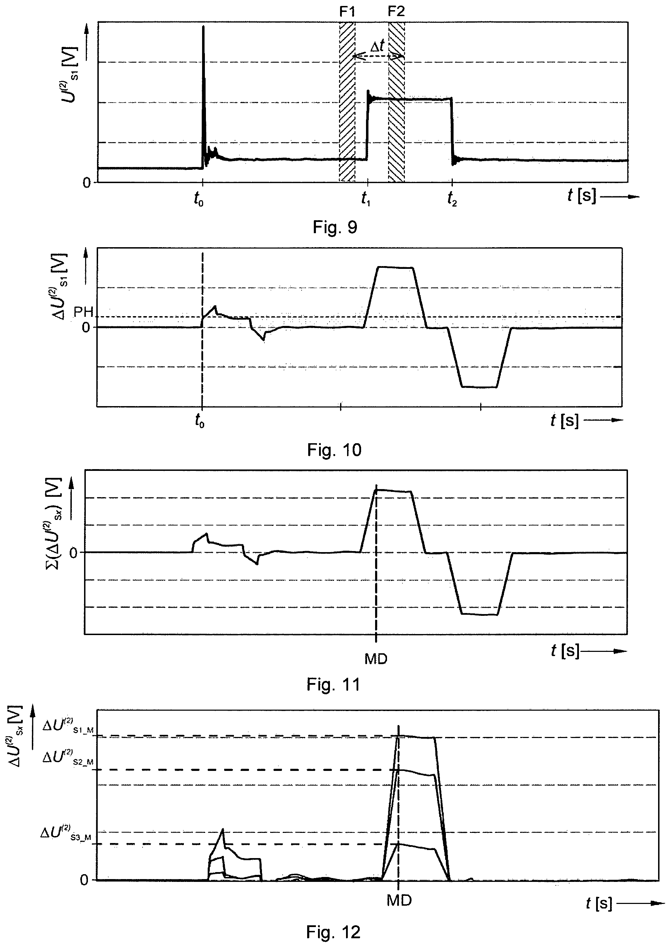

The negative sequence voltage is calculated from phase to neutral voltages which are measured by the MZSN 1. An example of such negative sequence voltage $U_{\mathrm{S1}}^{(2)}$ is presented in Fig. 9, where $t_0$ is time of fault inception and the time frame from $t_1$ to $t_2$ presents period when an auxiliary resistor $R_{\mathrm{p}}$ was switched. A connected auxiliary resistor $R_{\mathrm{p}}$ is used for increasing the value of the negative sequence voltage to ensure an easier identification and subtraction of voltage difference. For this waveform of negative sequence voltage, the mean values of the negative sequence voltage are continuously calculated for the time frames F1 and F2. Both the time frames are mutually shifted by time interval $\Delta t$. The width of the frames F1 and F2 as well as the time interval $\Delta t$ are adjustable according to the operation condition of the monitored network and according to the preset time for connecting the auxiliary resistor $R_{\mathrm{p}}$. In the presented example, the width of the time frames F1 and F2 is set to a value which corresponds to ten periods of system frequency and the time interval is $\Delta t = 0,5$s.

After that, the waveform of the change in the negative sequence voltage $\Delta U_{\mathrm{S1}}^{(2)}$ presented in Fig. 10 is continuously calculated as subtraction of the mean values of negative sequence voltage given time frames F1 and F2. At the time when a threshold value of change of negative sequence voltage PH is exceeded, in the presented case at the time to, which is the moment when the fault occurred, the change in the negative sequence voltage waveform $\Delta U_{\mathrm{S1}}^{(2)}$ is recorded and stored, including the preset pre-trigger and post-trigger, into the storage of the unit MZSN 1. If circular memory is used in MZSN 1, the change in the negative sequence voltage $\Delta U_{\mathrm{S}x}^{(2)}$ can be continuously saved to circular memory until the moment, when the record is required by the evaluation unit 3 for determined co-ordination time. After that, the record containing the predefined pre-trigger and post-trigger is transferred to evaluation unit 3.

The calculation and recording of a waveform of the change in the negative sequence current in the presented embodiment is realised in the unit MZSP 2 in an analogously manner.

The evaluation unit 3 downloads the records of the change in the negative sequence voltage $\Delta U_{\mathrm{S}x}^{(2)}$ from storage of all accessible monitors MZSN 1 and the change in the negative sequence current $\Delta I_{\mathrm{f}}^{(2)}$ from the storages of the monitoring units MZSP 2 for the co-ordination time or for the specific time of fault occurrence.

Second step

On the basis of all obtained records, which inform about $\Delta U_{\mathrm{S}x}^{(2)}$ and $\Delta I_{\mathrm{f}}^{(2)}$, the evaluation unit evaluates the time of maximum change in the negative sequence voltage and current, which corresponds to the moment, when the sum $\Sigma\left(\Delta U_{\mathrm{S}x}^{(2)}\right)$ of all recorded changes in the negative sequence voltage $\Delta U_{\mathrm{S}x}^{(2)}$ assumes its maximum value, as presented in Fig. 11. After that, the maximum change in the negative sequence voltage $\Delta U_{\mathrm{S}x\_\mathrm{M}}^{(2)}$ of the individual measuring points and the maximum change in the negative sequence current $\Delta I_{\mathrm{f\_M}}^{(2)}$ is selected for defined time of the maximum difference MD, as presented in Fig. 12 for the voltage, where time of the maximum difference MD corresponds with the maximum changes in the negative sequence voltage $\Delta U_{\mathrm{S1\_M}}^{(2)}$, $\Delta U_{\mathrm{S2\_M}}^{(2)}$, $\Delta U_{\mathrm{S3\_M}}^{(2)}$.

Third step

The maximum changes in the negative sequence voltage $\Delta U_{\mathrm{S}x\_\mathrm{M}}^{(2)}$ are converted with respect to the primary of the corresponding distribution transformer MV/LV and along with the maximum change in the negative sequence current $\Delta I_{f\_M}^{(2)}$ are used as input values for a location algorithm configured to calculate the probability of an asymmetrical fault occurrence in the individual nodes of a network, i.e. the source of voltage unbalance in an electrical distribution network.

If the maximum change in the negative sequence current is measured on the individual outgoing or incoming feeders of a medium voltage substation S-MV or on several power supply transformers HV/MV, the maximum change in the negative sequence current $\Delta I_{f\_M}^{(2)}$ required for the location algorithm has to be calculated by the formula (1) below:

$$\Delta I_{f\_M}^{(2)} = \sum_{y=1}^{k} \Delta I_{f\_M\,y}^{(2)} \tag{1}$$

Where:

k is the total number of all values of maximum change in the negative sequence current recorded by MZSP 2 in a protected part of the distribution network,

$\Delta I_{f\_M\,y}^{(2)}$ is the maximum change in the negative sequence current measured on appropriate measuring points.

Fourth step

A negative sequence scheme of the electrical distribution network is created such that power lines are split by auxiliary nodes PU into individual elements with predetermined maximum length. The maximum length of individual element of power lines can be specified by user. The maximum length of an individual element defines fault location accuracy of the location algorithm. The fault location accuracy of the location algorithm is higher for a lower maximum length of an individual element of a power line and vice versa. The scheme also comprises measuring nodes MU, i.e. nodes, where maximum change in the negative sequence voltage $\Delta U_{Sx\_M}^{(2)}$ was recorded.

Fifth step

The location algorithm subsequently connects the fault node FN to the appropriate nodes numbered from 1 up to $n$, where $n$ is the total number of all nodes PU, MU, and solves the equation (2) for all these states as follows:

$$\left[\Delta \overline{U}_n^{(2)}\right]^N = \left[\overline{Y}^{(2)}\right]^{-1} \cdot \left[-\Delta I_{f\_M}^{(2)}\right]^N \tag{2}$$

Where:

$N$ is the number of the nodes where a fault is being supposed / node FN is connected, where $N$ = 1, 2, ..., $n$,

$\left[\Delta \overline{U}_n^{(2)}\right]^N$ is a matrix of the calculated change in the negative sequence voltage in the individual nodes, supposing a fault in the node N,

$\left[\overline{Y}^{(2)}\right]$ is a nodal admittance matrix created from negative sequence scheme of the given distribution network,

$\left[-\Delta I_{f\_M}^{(2)}\right]^N$ is a matrix of the maximum change in negative sequence current caused by the supposed fault in node $N$.

The matrix $\left[\Delta \overline{U}_n^{(2)}\right]^N$ can be transformed to the equation (3) as follows:

$$\left[\Delta \overline{\mathrm{U}}_{\mathrm{n}}^{(2)}\right]^{N} = \left[\begin{array}{c}\left[\Delta \overline{\mathrm{U}}_{\mathrm{Sn}}^{(2)}\right]^{N} \\ \left[\Delta \overline{\mathrm{U}}_{\mathrm{PU}}^{(2)}\right]^{N}\end{array}\right] = \left[\begin{array}{c}\left[\begin{array}{c}\Delta \overline{U}_{\mathrm{Sn}\,1}^{(2)} \\ \Delta \overline{U}_{\mathrm{Sn}\,2}^{(2)} \\ \vdots \\ \Delta \overline{U}_{\mathrm{Sn}\,i}^{(2)}\end{array}\right]^{N} \\ \left[\begin{array}{c}\Delta \overline{U}_{\mathrm{PU}1}^{(2)} \\ \Delta \overline{U}_{\mathrm{PU}2}^{(2)} \\ \vdots \\ \Delta \overline{U}_{\mathrm{PU}\,k}^{(2)}\end{array}\right]^{N}\end{array}\right] \qquad (3)$$

Where:

$N$ is number of the nodes where a fault is being supposed, where $N= 1, 2, ..., n,$

$\left[\Delta \overline{\mathrm{U}}_{\mathrm{Sn}}^{(2)}\right]^{N}$ is a sub-matrix of the calculated change in the negative sequence voltage in measuring nodes MU, supposing a fault in the node $N$,

$i$ is the number of measuring nodes MU,

$\left[\Delta \overline{\mathrm{U}}_{\mathrm{PU}}^{(2)}\right]^{N}$ is a sub-matrix of the calculated change in the negative sequence voltage in all auxiliary nodes PU, supposing a fault in the node $N$,

$k$ is the number of auxiliary nodes PU.

An example of the equation (2) drawn up for the specific case of the fault in the node $N = 3$ is described by formula (4) is as follows:

$$\left[\Delta \overline{\mathrm{U}}_{\mathrm{n}}^{(2)}\right]^{3} = \left[\overline{\mathrm{Y}}^{(2)}\right]^{-1} \cdot \left[-\Delta \mathrm{I}_{\mathrm{f\_M}}^{(2)}\right]^{3}$$

$$\left[\begin{array}{c}\Delta \overline{U}_{\mathrm{n}\,1}^{(2)} \\ \Delta \overline{U}_{\mathrm{n}\,2}^{(2)} \\ \vdots \\ \Delta \overline{U}_{\mathrm{n}\,n}^{(2)}\end{array}\right]^{3} = \left[\begin{array}{c}\left[\begin{array}{c}\Delta \overline{U}_{\mathrm{Sn}\,1}^{(2)} \\ \Delta \overline{U}_{\mathrm{Sn}\,2}^{(2)} \\ \vdots \\ \Delta \overline{U}_{\mathrm{Sn}\,i}^{(2)}\end{array}\right]^{3} \\ \left[\begin{array}{c}\Delta \overline{U}_{\mathrm{PU}1}^{(2)} \\ \Delta \overline{U}_{\mathrm{PU}2}^{(2)} \\ \vdots \\ \Delta \overline{U}_{\mathrm{PU}\,k}^{(2)}\end{array}\right]^{3}\end{array}\right] = \left[\begin{array}{ccc}\overline{Y}_{11}^{(2)} & \cdots & \overline{Y}_{1n}^{(2)} \\ \vdots & \ddots & \vdots \\ \overline{Y}_{n1}^{(2)} & \cdots & \overline{Y}_{nn}^{(2)}\end{array}\right]^{-1} \cdot \left[\begin{array}{c}0 \\ 0 \\ -\Delta I_{\mathrm{f\_M}}^{(2)} \\ \vdots \\ 0\end{array}\right]^{3} \qquad (4)$$

Sixth step

In the next step, the location algorithm calculates an error of the changes in the negative sequence voltage $\varepsilon$ according to equation (5), which is given by difference between the absolute value of the calculated change of negative sequence voltage in the measuring nodes MU for supposed fault in a node $N$ and a recorded value of the maximum change in negative sequence voltage of the appropriate measuring nodes, as presented by the equation (5).

$$[\varepsilon]^N = \left[\left|\Delta\overline{U}_{Sn}^{(2)}\right|\right]^N - \left[\Delta U_{Sx\_M}^{(2)}\right] = \begin{bmatrix} \varepsilon_1^N \\ \varepsilon_2^N \\ \vdots \\ \varepsilon_i^N \end{bmatrix} = \begin{bmatrix} \left|\Delta\overline{U}_{Sn1}^{(2)}\right| - \Delta U_{S1\_M}^{(2)} \\ \left|\Delta\overline{U}_{Sn2}^{(2)}\right| - \Delta U_{S2\_M}^{(2)} \\ \vdots \\ \left|\Delta\overline{U}_{Sni}^{(2)}\right| - \Delta U_{Si\_M}^{(2)} \end{bmatrix}^N \tag{5}$$

Where:

$N$ is the number of the nodes where a fault is being supposed, where $N = 1, 2, ..., n$,
$[\varepsilon]^N$ is a matrix of errors of the change in the negative sequence voltage, if the fault is being supposed in the node N,
$i$ is the number of measuring nodes MU,

$\left|\Delta U_{Sx\_M}^{(2)}\right|$ is a matrix of the measured maximum change in the negative sequence voltage converted on a primary/medium voltage side of a distribution transformer MV/LV for node x = 1, 2, ...$i$.

Seventh step

An improvement of the fault location accuracy in a distribution network is possible with using of correction of errors $\varepsilon$ by global error $\delta^N$. The correction is made by subtracting the global error $\delta^N$ from all elements of the matrix $[\varepsilon]^N$, wherein $\delta^N$ is the value, respectively error, which is contained in all elements of the matrix $[\varepsilon]^N$.

Eighth step

In the next step, the matrix of the total errors [E] for all supposed faults location in nodes No. 1 to $n$ is calculated. The value of the total error $E_n$ can be calculated as arithmetical mean or as a sum of absolute values of errors $\varepsilon$ in all measuring nodes, as presented by equation (7). Supposing a fault in node $N$, the value of total error is calculated according to equation (6).

$$E_N = \sum_{p=1}^{i} \left|\varepsilon_p^N\right| \tag{6}$$

Where:

$N$ is the number of the node where the fault is being supposed, where N = 1, 2, ..., $n$.

$$[E] = \begin{bmatrix} E_1 \\ E_2 \\ \vdots \\ E_n \end{bmatrix} = \begin{bmatrix} \sum_{p=1}^{i} \left|\varepsilon_p^1\right| \\ \sum_{p=1}^{i} \left|\varepsilon_p^2\right| \\ \vdots \\ \sum_{p=1}^{i} \left|\varepsilon_p^n\right| \end{bmatrix} \tag{7}$$

Where:

$i$ is the number of measuring nodes MU.

If a correction based on the step 7 is considered, the equation (8) intended for the calculation of the total error $E_N$ respectively for the calculation of the elements of the matrix of the total errors [E] will be used:

$$E_N = \left( \sum_{p=1}^{i} \left| \varepsilon_p{}^N \right| \right) - i \cdot \delta^N \qquad (8)$$

Where:

N is the number of the node, where the fault is being supposed, where N = 1, 2, ..., n $i$ is the number of measuring nodes MU.

Ninth step

The element with the minimum value of the total error $E_{min}$ and the maximum value of the total error $E_{max}$ are selected from the matrix of total errors [E], and then the percentage probability of fault presence or presence of a source of voltage unbalance for nodes No. 1 to $n$ is calculated according to the equation (9):

$$F_N = \frac{E_{max} - E_N}{E_{max} - E_{min}} \cdot 100 \ [\%] \qquad (9)$$

Where:

$N$ is the number of the node, where the fault is being supposed, where $N = 1,$ 2, ..., n $F_N$ is a percentage value of the probability of fault presence or presence of a source of voltage unbalance in a node $N$.

Tenth step

In this step, a place of presence of a fault or a source of voltage unbalance is defined on the basis of the probability distribution for individual nodes no. 1 to $n$ according to results obtained through the matrix (10), where the element with the value 100% indicates the node with the probable fault location.
Where:

$N$ is the number of node with defined probability of fault presence, where $N = 1,$ 2,.. n

The results obtained by means of the location algorithm are used by the evaluation unit for the visualisation of a place with a fault or for transmitting it to another, superior system.

Exemplary embodiments

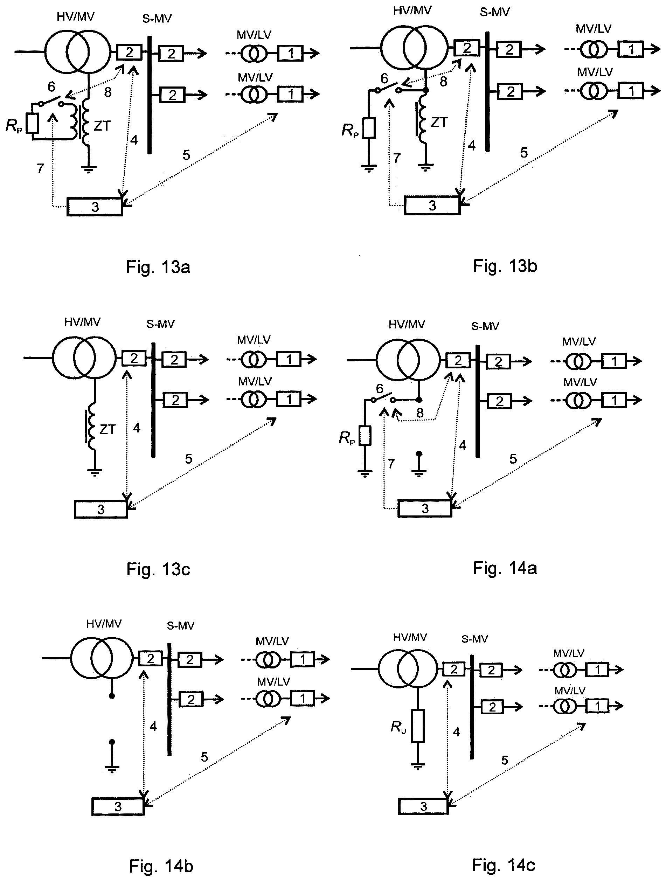

Figs. 13 and 14 present the examples of the configuration of individual components of the system for different types of distribution networks. The MZSP 2 are placed on the secondary side of a power supply transformer HV/MV in the individual incoming or outgoing feeder bays of a medium voltage substation S-MV. The units MZSN 1 are placed on the secondary sides of distribution transformers MV/LV. The units MZSP 2 and MZSN 1 are connected to the evaluation unit 3 by means of the two way communication 4 and 5. If an auxiliary resistor $R$p controlled by circuit breaker 6 is used, the evaluation unit 3 and/or the unit MZSP 2 is equipped by the communication 7 and/or 8 enabling the circuit breaker 6 to be controlled.

The first embodiment of the system presented in Figs. 13a and 13b is used in a resonant earthed distribution network, where, if a fault is detected, the evaluation unit 3 connects an auxiliary resistor $R$p to the power winding of the arc suppression coil ZT by switching the circuit breaker 6, see Fig. 13a, or in parallel to the arc suppression coil ZT, see Fig. 13b. In the embodiment depicted in Figs. 13a and 13b, the circuit breaker 6 can also be switched by means of a control impulse transmitted through the control communication 8 by the MZSP 2.

The second embodiment of the system presented in Fig. 13c is used in a resonant earthed distribution network without an auxiliary resistor $R_p$.

The third embodiment of the system presented in Fig. 14a is used in an isolated distribution network, where the evaluation unit 3 can transiently connect the auxiliary resistor $R_p$ to the neutral point of the transformer HV/MV through the circuit breaker 6 when a fault is detected. In the case of the described embodiment, the circuit breaker 6 can also be controlled by the MZSP 2 through the control communication 8.

The fourth embodiment of the system presented in Fig. 14b is used in an isolated distribution network.

The fifth embodiment of the system presented in Fig. 14c is used in a distribution network earthed through a resistor Ru or in an effectively earthed distribution network, where $R_\mathrm{u}=0\Omega$.

The system and the method according to the invention are applicable for locating an asymmetrical fault inside an isolated distribution network, a resonant earthed distribution network, a resonant earthed distribution network with automatic system for short-time connection of an auxiliary resistor, and inside an effectively earthed distribution network or a resistor earthed distribution network.

The system and the method according to the invention can be also used for locating a source of a voltage unbalance in a medium voltage distribution network.

An exceptionality of the invention consists in the possibility of an exact location of asymmetrical faults, e.g. single phase to earth fault, in a distribution network, which is operated as isolated, resonant or directly earthed, wherein recorded changes in the negative sequence voltage measured on the secondary side of a distribution transformer MV/LV are used for fault location. Based on that, a place with highest probability of presence of an asymmetrical fault or presence of a source of voltage/current unbalance can be defined in all types of distribution networks. According to the invention, the earth fault location can be carried out without interrupting the power supply and without any necessity of changing the configuration of a distribution network. Another exceptionality of the invention consists in the possibility of repeating the location process in case of finding a single phase to earth fault in resonant earthed or isolated distribution networks. This possibility can improve the location accuracy and also makes it possible to locate an earth fault in a case when the initial recorded data are not sufficient for the evaluation process. An advantage of the invention consists in using negative sequence impedances for the fault location process, because negative sequence impedances in comparison with commonly used zero sequence impedances are well known and more accurate. Another exceptionality of the invention consists in that it is not necessary to detect a faulty feeder prior the fault location process, wherein the accuracy of location depends on the size of determined individual elements of a network and on the number of installed MZSN units, wherein the installation of higher number of MZSN units and their placement closer to sections of a network which are frequently affected by a fault eliminates a risk of incorrect determination of a fault point, i.e. improves the accuracy of the location algorithm. Another advantage of the system consists in that it is possible to locate a fault even in a case when some of the monitoring units MZSN fails. The invention can be also used for locating a source of high voltage/current unbalance in a medium voltage distribution network for the purpose of eliminating the same, which improves the quality of the power supplied in a monitored network.

## Claims

1. Evaluation method for determination of probability of an asymmetrical fault location in a distribution network wherein

- a negative sequence scheme of a monitored distribution network is created,
- a co-ordination time of a fault occurrence is evaluated on the basis of time, when a threshold value of the change of negative sequence current or a threshold value of the zero sequence voltage is exceeded,
- the records of the changes of negative sequence voltage measured on the secondary sides of appropriate distribution transformers (MV/LV) and the records of the changes of negative sequence currents flowing through supply transformers (HV/MV) are collected for the given co-ordination time of fault occurrence,
- the maximum change of negative sequence voltage $\Delta \mathrm{U}^{(2)}_{\mathrm{S}x\_\mathrm{M}}$ is determined for individual measuring nodes (MU),
- the maximum change of negative sequence current $\Delta I^{(2)}_{\mathrm{f\_M\_y}}$ measured at appropriate measuring points is determined,

said $\Delta U^{(2)}_{Sx\_M}$ and $\Delta I^{(2)}_{f\_M\_y}$ are measured at appropriate measuring points being the moment when the sum of all the recorded changes of negative sequence voltage reaches its maximum value.

- a maximum change of negative sequence voltage $\Delta \mathrm{U}^{(2)}_{\mathrm{S}x\_\mathrm{M\_c}}$ on the primary side of the respective distribution transformer (MV/LV) is determined by conversion of each value of the maximum change of negative sequence voltage $\Delta \mathrm{U}^{(2)}_{\mathrm{S}x\_\mathrm{M}}$ to the primary side of the respective distribution transformer (MV/LV),

- matrix of the change of negative sequence voltage $\left[\Delta \overline{\mathrm{U}}^{(2)}_{\mathrm{n}}\right]$ is calculated by use of equation

$$\left[\Delta\overline{U}_n^{(2)}\right]^N = \left[\overline{Y}^{(2)}\right]^{-1} \cdot \left[-\Delta I_{f\_M}^{(2)}\right]^N$$

Where:

N is index of the number of the node, where the fault is being supposed,

$\left[\overline{Y}^{(2)}\right]$ is a nodal admittance matrix derived from the negative sequence scheme of the given distribution network,

$\left[-\Delta I_{f\_M}^{(2)}\right]$ is a matrix of the maximum change of negative sequence current, where $\Delta I_{f\_M}^{(2)}$ is created for a supposed fault in individual node N and calculated by use of equation

$$\Delta I_{f\_M}^{(2)} = \sum_{y=1}^{k} \Delta I_{f\_M_y}^{(2)}$$

Where:

$\Delta I_{f\_M_y}^{(2)}$ is a maximum change of negative sequence current measured at appropriate measuring points,

k is the total number of values of the maximum change of negative sequence current $\Delta I_{f\_M_y}^{(2)}$.

- subsequently a matrix of the calculated change of negative sequence voltage $\left[\Delta\overline{U}_{Sn}^{(2)}\right]$ of individual measuring nodes (MU) is determined as a sub-matrix from the matrix of the calculated change of negative sequence voltage $\left[\Delta\overline{U}_n^{(2)}\right]$ by use of equation

$$\left[\Delta\overline{U}_n^{(2)}\right]^N = \left[\begin{array}{c}\left[\Delta\overline{U}_{Sn}^{(2)}\right]^N \\ \left[\Delta\overline{U}_{PU}^{(2)}\right]^N\end{array}\right] = \left[\begin{array}{c}\left[\begin{array}{c}\Delta\overline{U}_{Sn\,1}^{(2)} \\ \Delta\overline{U}_{Sn\,2}^{(2)} \\ \vdots \\ \Delta\overline{U}_{Sn\,i}^{(2)}\end{array}\right]^N \\ \left[\begin{array}{c}\Delta\overline{U}_{PU1}^{(2)} \\ \Delta\overline{U}_{PU2}^{(2)} \\ \vdots \\ \Delta\overline{U}_{PU\,k}^{(2)}\end{array}\right]^N\end{array}\right]$$

Where:

$\left[\Delta\overline{U}_{Sn}^{(2)}\right]$ is matrix of the calculated change of negative sequence voltage of individual measuring nodes defined by number of measuring nodes (MU),

i is the number of measuring nodes (MU), and

N is index of the number of the node, where the fault is being supposed.

- subsequently a matrix [ε] of the errors of change of negative sequence voltage of individual measuring nodes (MU) is calculated by use of equation

$$[\varepsilon]^{N} = \left[\left|\Delta\overline{U}_{\mathrm{Sn}}^{(2)}\right|\right]^{N} - \left[\Delta U_{Sx\_M\_c}^{(2)}\right]^{N}$$

Where:

N is index of the number of the node, where the fault is being supposed,

$\left[\left|\Delta\overline{U}_{\mathrm{Sn}}^{(2)}\right|\right]^{N}$ is matrix of absolute values of the calculated change of negative sequence voltage of individual measuring nodes (MU),

$\left[\Delta U_{Sx\_M\_c}^{(2)}\right]^{N}$ is the matrix of the converted maximum change of negative sequence voltage of individual measuring nodes (MU).

- subsequently the total error $E_N$ between the calculated change of negative sequence voltage and the converted maximum change of negative sequence voltage of all measuring nodes (MU) is calculated from respective matrix $[\varepsilon]^N$ for individual node $N$,
- subsequently the matrix [E] of total errors $E$ of all individual nodes $N$ = 1, 2,..., n is created,
- subsequently the percentage value of the probability F of an asymmetrical fault presence for all individual nodes $N$ is calculated by use of equation

$$F_N = \frac{E_{\max} - E_N}{E_{\max} - E_{\min}} \cdot 100 \quad [\%]$$

Where:

N is index of the number of the node where the fault is being supposed, $E_{\min}$ is the minimum value of the matrix of the total error[E],
$E_{\max}$ is the maximum value of the matrix of the total error[E],
$E_N$ is total error for individual node N.

- subsequently an asymmetrical fault is localised by determination of the node with highest percentage value of the probability of an asymmetrical fault presence $F$.

2. Evaluation method according to claim 1, **characterized in that** a graphical visualisation depicting calculated probability of an asymmetrical fault presence for individual nodes is carried out.

3. Evaluation method according to claim 1, **characterized in that** the value of the total error $E_N$ is calculated as arithmetical mean or as a sum of absolute values of errors $\varepsilon$ in all nodes $N$ by use of equation

$$E_N = \sum_{p=1}^{i} \left|\varepsilon_p^{\ N}\right|$$

Where:

N is index of the number of the node where the fault is being supposed,
$i$ is index of the number of measuring nodes (MU),
$\varepsilon$ is error of change of negative sequence voltage of individual measuring node (MU).

**Patentansprüche**

1. Die Auswertungsmethode für die Bestimmung der Wahrscheinlichkeit der Stelle mit einem unsymmetrischen Defekt in dem Verteilungsnetz, wo

- das Schema der Gegenkomponente des betrachteten Verteilungssystems gebildet ist,
- die Koordinationszeit der Defektentstehung aufgrund der Zeit ausgewertet wird, wann der Schwellenwert der Gegenkomponente des Stromes oder der Schwellenwert der nicht drehenden Komponente des Stromes überschritten ist,
- die Aufzeichnungen von den Änderungen der auf den Sekundärseiten der Verteilungstransformatoren (MV/LV) gemessene Gegenkomponente der Spannung und die Aufzeichnungen der Änderungen der aus den Versorgungstransformatoren (HV/MV) bezogenen Gegenkomponenten des Stromes für die bestimmte Koordinationszeit der Defektentstehung versammelt werden,

- die Höchständerung der Gegenkomponente der Spannung $\Delta U_{Sx\_M}^{(2)}$ für einzelne Messknoten (MU) bestimmt ist,

- die Höchständerung der in den entsprechenden Messpunkten gemessenen Gegenkomponente des Stromes $\Delta I_{f\_M\_y}^{(2)}$ bestimmt ist,

- oben stehende , in den entsprechenden Messpunkten, gemessene $\Delta U_{Sx\_M}^{(2)}$ und $\Delta I_{f\_M\_y}^{(2)}$ entsprechen dem Moment, in dem die Summe aller aufgezeichneten Änderungen der Gegenkomponenten der Spannung ihr Maximum erreicht,

- die Höchständerung der Gegenkomponente der Spannung $\Delta U_{Sx\_M\_c}^{(2)}$ auf der Primärseite des entsprechenden Verteilungstransformators (MV/LV) durch Umrechnung einzelner Werte der Höchständerung der Gegenkomponente der Spannung $\Delta U_{Sx\_M}^{(2)}$ zu der Primärseite des entsprechenden Verteilungstransformators (MV/LV) bestimmt ist,

- die Änderungsmatrix der Gegenkomponente der Spannung $\left[\Delta\overline{U}_{n}^{(2)}\right]$ durch den Einsatz von der Gleichung

$$\left[\Delta\overline{U}_{n}^{(2)}\right]^{N} = \left[\overline{Y}^{(2)}\right]^{-1} \cdot \left[-\Delta I_{f\_M}^{(2)}\right]^{N}$$

berechnet ist
Wo:

N Index der Knotennummer mit dem voraussichtlichen Defekt ist,

$\left[\overline{Y}^{(2)}\right]$ die von dem Schema der Gegenkomponente des entsprechenden Verteilungssystems abgeleitete Knotenadmittanzmatrix ist,

$\left[-\Delta I_{f\_M}^{(2)}\right]$ die Matrix der Höchständerung der Gegenkomponente des Stromes ist, wo $\Delta I_{f\_M}^{(2)}$ für den voraussichtlichen Defekt in einzelnen Knoten N bestimmt ist und durch den Einsatz von der Gleichung

$$\Delta I_{f\_M}^{(2)} = \sum_{y=1}^{k} \Delta I_{f\_M_y}^{(2)}$$

berechnet ist

Wo: $\Delta I_{f\_M_y}^{(2)}$ die Höchständerung der in den entsprechenden Messpunkten gemessenen Gegenkomponente des Stromes ist,

k die Gesamtzahl der Werte der Höchständerung der Gegenkomponente des Stromes $\Delta I_{f\_M_y}^{(2)}$ ist.

- folglich die Matrix der berechneten Änderung der Gegenkomponente der Spannung $\left[\Delta\overline{U}_{Sn}^{(2)}\right]$ einzelner Messknoten (MU) als Submatrix aus der Matrix der berechneten Änderung der Komponente der Spannung $\left[\Delta\overline{U}_{n}^{(2)}\right]$ durch den Einsatz von der Gleichung

$$\left[\Delta\overline{U}_{\mathrm{n}}^{(2)}\right]^{N} = \left[\begin{matrix}\left[\Delta\overline{U}_{\mathrm{Sn}}^{(2)}\right]^{N}\\\left[\Delta\overline{U}_{\mathrm{PU}}^{(2)}\right]^{N}\end{matrix}\right] = \left[\begin{matrix}\left[\begin{matrix}\Delta\overline{U}_{\mathrm{Sn}\,1}^{(2)}\\\Delta\overline{U}_{\mathrm{Sn}\,2}^{(2)}\\\vdots\\\Delta\overline{U}_{\mathrm{Sn}\,i}^{(2)}\end{matrix}\right]^{N}\\\left[\begin{matrix}\Delta\overline{U}_{\mathrm{PU}1}^{(2)}\\\Delta\overline{U}_{\mathrm{PU}2}^{(2)}\\\vdots\\\Delta\overline{U}_{\mathrm{PU}k}^{(2)}\end{matrix}\right]^{N}\end{matrix}\right]$$

bestimmt ist
Wo:

$\left[\Delta\overline{U}_{\mathrm{Sn}}^{(2)}\right]$ die Matrix der berechneten Änderungen der Gegenkomponente der Spannung einzelner Messknoten durch die Anzahl der Messknoten (MU) gegeben ist,
$i$ die Anzahl der Messknoten (MU) ist, und
$N$ Index der Knotennummer mit dem voraussichtlichen Defekt ist.

- folglich die Matrix [$\varepsilon$]der Defekte der Änderung der Gegenkomponente der Spannung einzelner Messknoten (MU) durch den Einsatz von der Gleichung

$$\left[\varepsilon\right]^{N} = \left[\left|\Delta\overline{U}_{\mathrm{Sn}}^{(2)}\right|\right]^{N} - \left[\Delta U_{Sx\_M\_c}^{(2)}\right]^{N}$$

berechnet ist
Wo:

N Index der Knotennummer mit dem voraussichtlichen Defekt ist,

$\left[\left|\Delta\overline{U}_{\mathrm{Sn}}^{(2)}\right|\right]^{N}$ die Matrix der absoluten Werte der berechneten Änderungen der Gegenkomponente der Spannung einzelner Messknoten (MU) ist,

$\left[\Delta U_{Sx\_M\_c}^{(2)}\right]^{N}$ die Matrix der umgerechneten Höchständerung der Gegenkomponente der Spannung einzelner Messknoten (MU) ist.

- folglich der Gesamtdefekt $E_{\mathrm{N}}$ zwischen der berechneten Änderung der Gegenkomponente der Spannung und der umgerechneten Höchständerung der Gegenkomponente der Spannung aller Messknoten (MU) aus der entsprechenden Matrix
[$\varepsilon$]$^{N}$ für den einzelnen Knoten N berechnet ist,
- folglich die Matrix [E] der Gesamtdefekte E einzelner Knoten N = 1, 2, ..., n gebildet ist,
- folglich der prozentuelle Wahrscheinlichkeitswert $F$ des Vorkommen des unsymmetrischen Defekts für alle einzelnen Knoten $N$ durch den Einsatz von der Gleichung

$$F_{N} = \frac{E_{\max} - E_{N}}{E_{\max} - E_{\min}} \cdot 100 \qquad [\%]$$

berechnet ist

Wo:

N Index der Knotennummer mit dem voraussichtlichen Defekt ist und $E_{min}$ der Mindestwert der Matrix der Gesamtdefekte [E] ist,
*Emax* der Höchstwert der Matrix der Gesamtdefekte [E] ist,
$E_N$ der Gesamtdefekt für den individuellen Knoten *N* ist.

- folglich der unsymmetrische Defekt an der Stelle des Knotens mit dem Höchstwert der Wahrscheinlichkeit des Vorkommens eines unsymmetrischen Defekts *F* ist.

2. Die Auswertungsmethode nach Anspruch 1 **dadurch gekennzeichnet, dass** die grafische Visualisierung, die die berechnete Wahrscheinlichkeit des Vorkommens eines unsymmetrischen Defekts für einzelne Knoten veranschaulicht, durchgeführt ist.

3. Die Auswertungsmethode nach Anspruch 1 **dadurch gekennzeichnet, dass** der Wert des Gesamtdefekts $E_N$ als arithmetisches Mittel oder als Summe der absoluten Werte der Defekte ε für alle Knoten *N* durch den Einsatz von der Gleichung

$$E_N = \sum_{p=1}^{i} \left| \varepsilon_p^{\,N} \right|$$

berechnet ist
Wo:

N Index der Knotennummer mit dem voraussichtlichen Defekt ist,
*i* Index der Messknotennummer (MU) ist,
ε der Defekt der Gegenkomponente der Spannung des einzelnen Messknotens (MU) ist.

**Revendications**

1. Méthode d'évaluation pour la détermination de la probabilité de la localisation d'un défaut asymétrique dans un réseau de distribution où

- le schéma inverse du réseau de distribution surveillé est créé,
- le temps de coordination de l'apparition du défaut est évalué sur la base du temps où la valeur seuil du courant inverse ou la valeur seuil de la tension homopolaire est dépassée,
- les enregistrements des changements de tension inverse mesurés aux côtés secondaires des transformateurs de distribution (HTA/BT) et les enregistrements des changements des courants inverses traversant les transformateurs aux postes de transformation (HTB/HTA) sont collectés pour le temps de coordination de l'apparition du défaut donné,
- le changement maximum de tension inverse $\Delta \mathrm{U}_{Sx\_\mathrm{M}}^{(2)}$ est déterminé pour chacun des noeuds de mesure (MU),
- le changement maximum de courant inverse $\Delta I_{\mathrm{f\_M\_y}}^{(2)}$ mesuré aux points de mesure correspondants est déterminé,
- ces valeurs $\Delta \mathrm{U}_{Sx\_\mathrm{M}}^{(2)}$ et $\Delta I_{\mathrm{f\_M\_y}}^{(2)}$, mesurés aux points de mesure, correspondent au moment où la somme tous les changements de tension inverse enregistrés atteint son maximum,
- le changement maximum de tension inverse $\Delta \mathrm{U}_{Sx\_\mathrm{M\_c}}^{(2)}$ au côté primaire du transformateur de distribution (HTA/BT) correspondant est déterminé par la conversion de chacune des valeurs du changement maximum de tension inverse $\Delta \mathrm{U}_{Sx\_\mathrm{M}}^{(2)}$ au côté primaire du transformateur de distribution (HTA/BT) correspondant,
- la matrice des changements de tension inverse $\left| \Delta \overline{\mathrm{U}}_{\mathrm{n}}^{(2)} \right|$ est calculée en utilisant la formule

$$\left[\Delta \overline{\mathrm{U}}_{\mathrm{n}}^{(2)}\right]^{N} = \left[\overline{\mathrm{Y}}^{(2)}\right]^{-1} \cdot \left[-\Delta \mathrm{I}_{\mathrm{f\_M}}^{(2)}\right]^{N}$$

Où:

$N$ est l'indice du nombre du noeud où le défaut est supposé apparaître,

$\left[\overline{\mathrm{Y}}^{(2)}\right]$ est la matrice des admittances nodales dérivée du schéma inverse du réseau de distribution donné,

$\left[-\Delta \mathrm{I}_{\mathrm{f\_M}}^{(2)}\right]$ est la matrice du changement maximum de courant inverse, où $\Delta I_{\mathrm{f\_M}}^{(2)}$ est déterminé pour chacun des noeuds $N$ où le défaut est supposé apparaître et calculé en utilisant la formule

$$\Delta I_{\mathrm{f\_M}}^{(2)} = \sum_{y=1}^{k} \Delta I_{\mathrm{f\_M}_y}^{(2)}$$

Où:

$\Delta I_{\mathrm{f\_M}_y}^{(2)}$ est le changement maximum de courant inverse mesuré aux points de mesure correspondants,

$k$ est le nombre total des valeurs du changement maximum de courant inverse $\Delta I_{\mathrm{f\_M}_y}^{(2)}$.

- ensuite, la matrice du changement calculé de tension inverse $\left[\Delta \overline{\mathrm{U}}_{\mathrm{Sn}}^{(2)}\right]$ de chacun des noeuds de mesure (MU) est déterminée comme une sous-matrice à partir de la matrice du changement calculé de tension inverse $\left[\Delta \overline{\mathrm{U}}_{\mathrm{n}}^{(2)}\right]$ utilisant la formule

$$\left[\Delta \overline{\mathrm{U}}_{\mathrm{n}}^{(2)}\right]^{N} = \left[\begin{bmatrix}\Delta \overline{\mathrm{U}}_{\mathrm{Sn}}^{(2)}\end{bmatrix}^{N} \\ \begin{bmatrix}\Delta \overline{\mathrm{U}}_{\mathrm{PU}}^{(2)}\end{bmatrix}^{N}\right] = \begin{bmatrix} \begin{bmatrix} \Delta \overline{U}_{\mathrm{Sn}\,1}^{(2)} \\ \Delta \overline{U}_{\mathrm{Sn}\,2}^{(2)} \\ \vdots \\ \Delta \overline{U}_{\mathrm{Sn}\,i}^{(2)} \end{bmatrix}^{N} \\ \begin{bmatrix} \Delta \overline{U}_{\mathrm{PU}1}^{(2)} \\ \Delta \overline{U}_{\mathrm{PU}2}^{(2)} \\ \vdots \\ \Delta \overline{U}_{\mathrm{PU}\,k}^{(2)} \end{bmatrix}^{N} \end{bmatrix}$$

Où:

$\left[\Delta \overline{\mathrm{U}}_{\mathrm{Sn}}^{(2)}\right]$ est la matrice des changements calculés de tension inverse de chacun des noeuds de mesure définie par le nombre de noeuds de mesure (MU),
$i$ est le nombre de noeuds de mesure (MU), et
$N$ est l'indice du nombre du noeud où le défaut est supposé apparaître.

- ensuite, la matrice $[\varepsilon]$ des erreurs du changement de tension inverse de chacun des noeuds de mesure (MU) est calculée en utilisant la formule

$$\left[\varepsilon\right]^{N} = \left[\left|\Delta \overline{\mathrm{U}}_{\mathrm{Sn}}^{(2)}\right|\right]^{N} - \left[\Delta \mathrm{U}_{Sx\_M\_c}^{(2)}\right]^{N}$$

Où ::

N est l'indice nombre du noeud où le défaut est supposé apparaître,

$\left[\left|\Delta \overline{\mathrm{U}}_{\mathrm{Sn}}^{(2)}\right|\right]^{N}$ est la matrice des valeurs absolues des changements calculés de tension inverse de chacun des noeuds de mesure (MU),

$\left[\Delta \mathrm{U}_{Sx\_M\_c}^{(2)}\right]^{N}$ est la matrice du changement maximum converti de tension inverse de chacun des noeuds de mesure (MU).

- ensuite, l'erreur totale $E_N$ entre le changement de tension inverse calculé et le changement maximum converti de tension inverse de tous les noeuds de mesure (MU) est calculée de la matrice $[\varepsilon]^N$ correspondante pour le noeud N,
- ensuite, la matrice [E] des erreurs totales E de tous les noeuds N = 1, 2,..., n est créée,
- ensuite, la valeur (en pourcentage) de la probabilité F de la présence d'un défaut asymétrique pour tout les noeuds N est calculée en utilisant la formule

$$F_{N} = \frac{E_{\max} - E_{N}}{E_{\max} - E_{\min}} \cdot 100 \qquad [\%]$$

Où ::

N est l'indice du nombre du noeud où le défaut est supposé apparaître,
$E_{\min}$ est la valeur minimum de la matrice des erreurs totales [E],
$Emax$ est la valeur maximum de la matrice des erreurs totales [E],
$E_N$ est l'erreur totale pour le noeud N.

- ensuite, le défaut asymétrique est localisé par la détermination du noeud avec la valeur de la probabilité F de la présence d'un défaut asymétrique la plus élevée.

2. Méthode d'évaluation selon la revendication 1, **caractérisée en ce que** une visualisation graphique représentant la probabilité calculée de l'apparition d'un défaut asymétrique pour chacun des noeuds est effectuée.

3. Méthode d'évaluation selon la revendication 1, **caractérisée en ce que** la valeur de l'erreur totale $E_N$ est calculée comme la moyenne arithmétique ou comme la somme des valeurs absolues des erreurs $\varepsilon$ pour tous les noeuds N en utilisant la formule

$$E_{N} = \sum_{p=1}^{i} \left| \varepsilon_{p}^{\;N} \right|$$

Où :

N est l'indice du nombre du noeud où le défaut est supposé apparaître,
i est l'indice du nombre de noeuds de mesure (MU),
$\varepsilon$ est l'erreur du changement de tension inverse de noeud de mesure (MU).

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13a

Fig. 13b

Fig. 13c

Fig. 14a

Fig. 14b

Fig. 14c

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Statistical Estimation of the Source and Level of Voltage Unbalance in Distribution Networks. **NICK C WOOLLEY et al.** IEEE Transactions on power delivery. IEEE Service Center, 01 July 2012, vol. 27, 1450-1460